# EUROPÄISCHE PATENTANMELDUNG

(11) **EP 4 815 001 A1**
(43) Veröffentlichungstag der Anmeldung: **30.09.2026**
(21) Anmeldenummer: 25166872.9
(22) Anmeldetag: 28.03.2025
(51) Int. Cl.: H01F 27/06, H01F 27/40, H02M 3/00

(54) **STROMRICHTERTURM MIT ELEKTROMAGNETISCHER ENTSTÖRVORRICHTUNG**

(71) Anmelder: Siemens Energy Global GmbH & Co. KG, 81739 München (DE)
(72) Erfinder: Priebe, Torsten, 91096 Möhrendorf (DE); Leicht, Anne-Christine, 91056 Erlangen (DE); Stingl, Stefan, 90455 Nürnberg (DE); Eismann, Christopher, 91330 Eggolsheim (DE); De Marinis, Luigi, 90419 Nürnberg (DE); Schlereth, Christoph, 97723 Oberthulba (DE); Schrammel, Christian, 90559 Burgthann (DE); Seibert, Günter, 90768 Fürth (DE); Stenglein, Erika, 91355 Hiltpoltstein (DE); Rabus, Heiko, 91790 Geyern (DE); Vieth, Michael, 90482 Nürnberg (DE)

(57) **Zusammenfassung**

Die Erfindung betrifft einen Stromrichterturm (1) mit einer Mehrzahl von Stromrichtermodulen (3), mit einer Mehrzahl von elektrischen Verbindungsleitern (9), von denen jeweils ein Verbindungsleiter (9) je zwei der Stromrichtermodule (3) miteinander oder eines der Stromrichtermodule (3) mit einer Anschlussleitung (11) des Stromrichterturms (1) verbindet. Um Emissionen auf einfache Weise wirksam zu unterbinden, ist erfindungsgemäß vorgesehen, dass wenigstens einer der elektrischen Verbindungsleiter (9) mit einer elektromagnetischen Entstörvorrichtung (13) versehen ist.

## Beschreibung

Die Erfindung betrifft einen Stromrichterturm mit einer Mehrzahl von Stromrichtermodulen, insbesondere in Reihenschaltung, mit einer Mehrzahl von elektrischen Verbindungsleitern, von denen jeweils ein Verbindungsleiter je zwei der Stromrichtermodule des Stromrichterturms miteinander oder eines der Stromrichtermodule mit einer Anschlussleitung des Stromrichterturms verbindet.

Stromrichtertürme können Bestandteile von Stromrichteranlagen sein, die wiederum bei der Hochspannungs-GleichstromÜbertragung (HGÜ) zum Einsatz kommen können. Die Stromrichtertürme sind in der Regel in Stromrichterhallen angeordnet. Dabei können die Stromrichtertürme entweder stehend oder hängend in der Stromrichterhalle angeordnet sein. Die Stromrichter können insbesondere Umrichter sein. Stromrichtermodule sind auch als Powermodule oder Submodule bekannt.

Schaltvorgänge in den Stromrichtermodulen können unerwünschte hochfrequente und transiente Störströme erzeugen. Die leitungs- und feldgebundenen Störungen, die durch den Betrieb des HGÜ-Stromrichters hervorgerufen werden, basieren auf physikalischen Prozessen, die während eines Schaltvorgangs eines Stromrichter-Submoduls auftreten. Durch das Schalten eines Stromrichter-Submoduls entstehen steile Spannungssprünge an seinen Anschlüssen (Aufschalten der Zwischenkreisspannung eines Submodul-Kondensators). Die Anstiegs- bzw. Abfallzeiten befinden sich in einem Zeitbereich von einigen Mikrosekunden, sodass durch diese Spannungssprünge unerwünschte hochfrequente, transiente Störströme entstehen. An allen Punkten, an denen hochspannungsführende Leiter die geschirmte Stromrichterhalle verlassen, können sich die leitungsgebundenen Störungen auch auf die luftisolierten Schaltanlagen und den daran angeschlossenen Hochspannungsleitungen im Außenbereich der HGÜ-Anlage ausbreiten. In diesen Bereichen können sich die Störsignale auch feldgebunden in die Umgebung ausbreiten und so eine Störaussendung der HGÜ-Anlage hervorrufen. Aufgrund einer stochastischen Häufigkeitsverteilung der Schaltvorgänge der Stromrichter-Submodule entsteht ein breitbandiges elektromagnetisches Störsignal, das als kontinuierlich angenommen werden kann.

Es kann erforderlich sein, die elektromagnetische Störaussendung der HGÜ-Anlage zu limitieren, um zu verhindern, dass fremde Geräte und Anlagen in der Umgebung der HGÜ-Anlage (im Kilometerbereich) durch die Störungen in ihrer ordnungsgemäßen Funktion beeinträchtigt werden. Als Beispiel sind hier Funkeinrichtungen zu nennen.

Um Störaussendung zu vermeiden oder zumindest zu unterdrücken, ist es bekannt, Entstördrosseln außerhalb der Stromrichterhalle an den AC- oder DC-Leitungen anzubringen.

Es ist die Aufgabe der Erfindung, elektromagnetische Störsignale, die von Stromrichteranlagen ausgehen, auf einfache und wirksame Art zu unterdrücken.

Diese Aufgabe ist erfindungsgemäß durch einen Stromrichterturm gemäß dem unabhängigen Anspruch 1 und durch eine Stromrichteranlage gemäß Anspruch 9 gelöst.

Der erfindungsgemäße Stromrichterturm zeichnet sich dadurch aus, dass wenigstens einer der elektrischen Verbindungsleiter mit einer elektromagnetischen Entstörvorrichtung versehen ist.

Die Anordnung einer Entstörvorrichtung an einem Verbindungsleiter eines Stromrichterturms sorgt dafür, dass die Störungen nahe an ihrer Ursache gedämpft werden. Dadurch ist eine effiziente Dämpfung möglich.

Da die Spannungen innerhalb eines Stromrichterturms kleiner sind als die Spannungen auf den Freileitungen außerhalb der Stromrichterhalle, können die Entstörvorrichtungen kleiner dimensioniert sein. Im Gegensatz zu Entstörvorrichtungen außerhalb der Stromrichtertürme, bei denen aufgrund der hohen Spannungen große Isolationsstrecken einzuhalten wären, können die Isolationsstrecken durch die niedrigeren Spannungen in den Stromrichtertürmen kleiner ausfallen. Dadurch kann die Entstörung sogar platzneutral erfolgen.

Mit dem Begriff "Verbindungsleiter" sollen die elektrischen Leiter gemeint sein, die die elektrische Energie zwischen den Stromrichtermodulen weiterleiten. Ein Verbindungsleiter kann ein elektrischer Leiter zwischen zwei Stromrichtermodulen desselben Stromrichterturms sein. Darüber hinaus kann ein Verbindungsleiter eine Verbindung zwischen einem Stromrichtermodul eines Stromrichterturms und einer Anschlussleitung, über die dieser Stromrichterturm mit einer weiteren Komponente der Stromrichteranlage, insbesondere mit einem anderen Stromrichterturm, herstellen. In beiden Fällen befinden sich die elektrischen Verbindungsleiter am oder im Stromrichterturm. Nicht gemeint sind mit dem Begriff gegebenenfalls vorhandene Daten- und Steuerleitungen.

Die erfindungsgemäße Lösung kann durch verschiedene, jeweils für sich vorteilhafte, beliebig miteinander kombinierbare Ausgestaltungen weiter verbessert werden. Auf diese Ausgestaltungsformen und die mit ihnen verbundenen Vorteile ist im Folgenden eingegangen.

Gemäß einer ersten vorteilhaften Ausgestaltung des Stromrichterturms kann dieser eine Mehrzahl übereinander angeordneter Etagen aufweisen, wobei auf jeder Etage eine Teilmenge der Mehrzahl von Stromrichtermodulen angeordnet ist, und wobei jede Etage mit wenigstens einer elektromagnetischen Entstörvorrichtung versehen ist. Die Ausgestaltung von Stromrichtertürmen mit mehreren Etagen ist bekannt. Jede Etage ist in der Regel mit einer Mehrzahl von Stromrichtermodulen versehen. Die Anzahl der Entstörvorrichtungen kann der Anzahl der Stromrichtermodule einer Etage entsprechen. Vorzugsweise ist die Anzahl der elektromagnetischen Entstörvorrichtungen je Etage geringer als die Anzahl der Stromrichtermodule auf dieser Etage. Besonders bevorzugt ist genau eine elektromagnetische Entstörvorrichtung je Etage vorgesehen.

Die Stromrichtermodule eines Stromrichterturms sind in der Regel miteinander in Reihe geschaltet. Dabei sind häufig die Stromrichtermodule einer Etage miteinander in Reihe geschaltet, wobei das erste oder letzte Stromrichtermodul der Reihenschaltung von Stromrichtermodulen einer Etage mit dem ersten oder dem letzten Stromrichtermodul einer Reihenschaltung von Stromrichtermodulen einer anderen Etage mittels einem der elektrischen Verbindungsleiter elektrisch leitend verbunden ist. Gemäß einer vorteilhaften Ausgestaltung kann wenigstens eine elektromagnetische Entstörvorrichtung einer Etage an einem solchen elektrischen Verbindungsleiter angeordnet sein, der zwei Stromrichtermodule benachbarter, insbesondere übereinander angeordneter, Etagen miteinander verbindet.

Wenigstens eine Teilmenge der elektrischen Verbindungsleiter kann als Stromschienen ausgestaltet sein.

Vorzugsweise ist wenigstens ein elektrischer Verbindungsleiter zumindest in dem Bereich, in dem eine der elektromagnetischen Entstörvorrichtungen angeordnet ist, mit einem runden Querschnitt versehen. In diesem Bereich kann der elektromagnetische Verbindungsleiter insbesondere als Rundleiter, bevorzugt aus Kupfer oder einem kupferhaltigen Werkstoff, gebildet sein. Vor und hinter dem Bereich, in dem die elektromagnetische Entstörvorrichtung angeordnet ist, kann der elektrische Verbindungsleiter als Stromschiene weitergeführt werden. Der Rundleiter ist selbstverständlich elektrisch leitend mit dem übrigen als Stromschiene ausgestalteten elektrischen Verbindungsleiter verbunden. Der Rundleiter kann zudem durch geeignete Befestigungsmittel mit der Stromschiene mechanisch verbunden und durch die Stromschienen gehalten sein. Ist eine höhere mechanische Stabilität nötig, kann der Rundleiter auch über isolierende Befestigungsmittel mit dem Stromrichterturm, insbesondere mit einem Rahmen des Stromrichterturms verbunden sein. Dadurch kann verhindert werden, dass das Gewicht der Entstörvorrichtung von den Stromschienen getragen werden muss, da diese in der Regel aus einem weichen Material bestehen.

Um gleichzeitig effektiv wirksame aber einfach aufgebaute und leicht herzustellende Entstörvorrichtungen zu erhalten, können wenigstens eine, vorzugsweise alle, der elektromagnetischen Entstörvorrichtungen aus einer Mehrzahl von magnetischen Ringkernen aufgebaut sein, wobei zentrale Öffnungen der Ringkerne miteinander fluchtend angeordnet sind und einen Kanal bilden, wobei einer der elektrischen Verbindungsleiter zumindest abschnittsweise durch diesen Kanal hindurchragt. Vorzugsweise sind die zentralen Öffnungen kreisrund. Wie bereits oben beschrieben, kann der Abschnitt des elektrischen Verbindungsleiters, an dem die Entstörvorrichtung angeordnet ist, mit einem kreisrunden Querschnitt versehen sein. Der elektrische Verbindungsleiter und die Ringkerne können also komplementär zueinander geformt sein. Vorzugsweise ist eine elektrisch isolierende Schicht zwischen dem Verbindungsleiter und den Ringkernen vorgesehen, beispielsweise aus Luft oder aus einem Kunststoff.

Die einzelnen Ringkerne sind vorzugsweise zu einem Stapel aufgeschichtet. Ein solcher Stapel von Ringkernen wird auch als Entstörpaket bezeichnet. Die magnetischen Ringkerne können aus Ferriten, vorzugsweise aus Eisenpulver, gebildet sein. Der Stapel von Ringkernen kann von einer elektrisch isolierenden Hülle eingehaust sein, wobei die Hülle Öffnungen zur Durchführung des Verbindungsleiters aufweist.

Bevorzugt ist die wenigstens eine elektromagnetische Entstörvorrichtung ausgestaltet, Frequenzen von 0,009-30 MHz, insbesondere Frequenzen von 0,5-30 MHz zu dämpfen.

Zur weiteren Erläuterung der Erfindung wird im nachfolgenden Teil der Beschreibung auf Figuren Bezug genommen, aus denen weitere vorteilhafte Einzelheiten und mögliche Einsatzgebiete der Erfindung zu entnehmen sind. Die Figuren sind als beispielhaft zu verstehen und sollen den Erfindungscharakter zwar darlegen, ihn aber keinesfalls einengen oder gar abschließend wiedergeben. Für Elemente mit gleichem Aufbau und/oder gleicher Funktion werden stets dieselben Bezugszeichen verwendet.

Es zeigen:
- Fig. 1: eine perspektivische Darstellung einer beispielhaften Ausführungsform eines Stromrichterturms;
- Fig. 2: ein Detail des Stromrichterturms aus Fig. 1;
- Fig. 3: eine perspektivische Darstellung einer Entstörvorrichtung an einem Verbindungsleiter; und
- Fig. 4: eine Simulation der Emissionen einer Stromrichteranlage mit und ohne elektromagnetischen Entstörvorrichtungen.

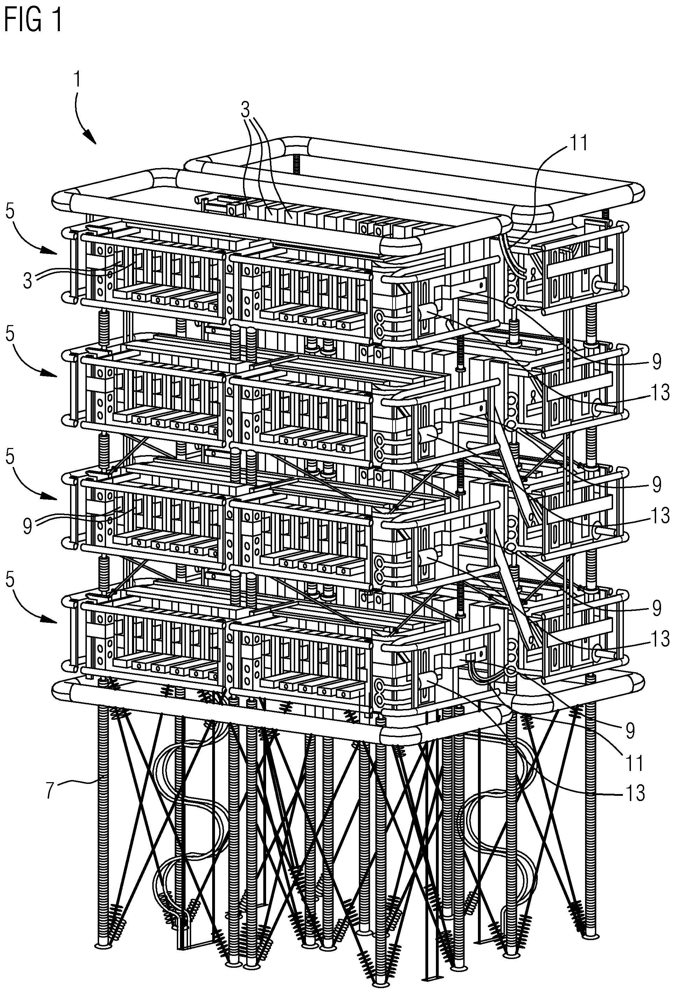

Im Folgenden ist zunächst auf einen Stromrichterturm 1 mit Bezug auf die Fig. 1 eingegangen.

Der Stromrichterturm 1 ist in der Regel Teil einer Stromrichteranlage (nicht gezeigt), die eine Mehrzahl von Stromrichtertürmen 1 umfasst.

Der Stromrichterturm 1 weist eine Mehrzahl von Stromrichtermodulen 3 auf. Stromrichtermodule 3 sind auch als Powermodule oder Submodule bekannt. Jedes der Stromrichtermodule 3 kann Schalteinheiten aufweisen, die jeweils aus Leistungshalbleiterschaltern und Dioden zusammengesetzt sein können. Die Schalteinheiten eines Stromrichtermoduls 3 können beispielsweise in Halbbrücken- oder Vollbrückenschaltung miteinander verbunden sein. In Fig. 1 sind der Übersichtlichkeit halber nur eine kleine Zahl von Stromrichtermodulen 3 gekennzeichnet.

Der Stromrichterturm 1 weist mehrere übereinander angeordnete Etagen 5 auf, in denen die Stromrichtermodule 3 angeordnet sind. Jede Etage 5 ist mit einer Mehrzahl von Stromrichtermodulen 3 versehen. Der beispielhaft dargestellte Stromrichtermodule 3 weist insgesamt vier Etagen auf, diese Anzahl ist jedoch nicht zwingend.

Der in Fig. 1 dargestellte Stromrichterturm 1 ist mit Stützen 7 versehen, so dass er in einer Stromrichterhalle aufgestellt werden kann. Alternativ zur stehenden Anordnung kann der Stromrichterturm 1 auch in der Stromrichterhalle aufgehängt sein. Die Stützen 7 können dann entfallen.

Die Stromrichtermodule 3 zumindest einer Etage 5 des Stromrichterturms 1, bevorzugt alle Stromrichtermodule 3 des Stromrichterturms 1 sind miteinander in einer Reihenschaltung verschaltet. Dabei sind jeweils zwei in der Reihenschaltung hintereinander geschaltete Stromrichtermodule 3 über einen Verbindungsleiter 9 miteinander verbunden. Da sich die Reihenschaltung auch über die Etagen 5 erstreckt, sind auch Stromrichtermodule 3 verschiedener Etagen 5 über Verbindungsleiter 9 miteinander verbunden.

Mehrere Stromrichtertürme 1 können über Anschlussleitungen 11 miteinander verbunden sein. Eine Anschlussleitung kann mit dem ersten oder letzten Stromrichtermodul 3 eines Stromrichterturms 1 über einen Verbindungsleiter 9 auf dem Stromrichterturm 1 verbunden sein.

Von den vorne rechts in Fig. 1 zu sehenden vier Verbindungsleitern 9 verbinden drei jeweils ein Stromrichtermodul 3 einer Etage 5 mit einem Stromrichtermodul 3 einer anderen Etage 5. Der vierte Verbindungsleiter 9, in Fig. 1 der unterste Verbindungsleiter 9, verbindet ein Stromrichtermodul 3 der untersten der Etagen 5 mit einer Anschlussleitung 11.

Auf jeder Etage 5 ist einer der Verbindungsleiter 9 mit einer elektromagnetischen Entstörvorrichtung 13 versehen, um die elektromagnetische Störaussendung zu minimieren. Der Stromrichterturm 1 weist also eine elektromagnetische Entstörvorrichtung 13 je Etage 5 auf. Alternativ dazu kann der Stromrichterturm 1 mit einer abweichenden Anzahl von elektromagnetischen Entstörvorrichtungen 13 versehen sein.

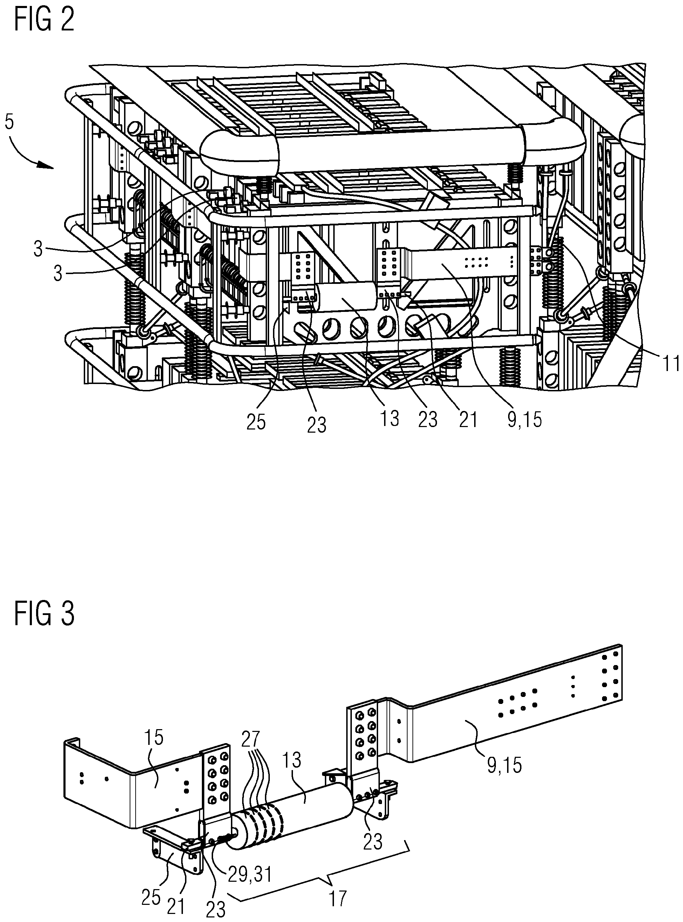

Im Folgenden ist auf die elektromagnetischen Entstörvorrichtungen 13 eingegangen, wobei auch Bezug auf die Figuren 2 und 3 genommen wird.

Fig. 2 zeigt einen Ausschnitt einer Verbindungsleitung 9 mit einer elektromagnetischen Entstörvorrichtung 13 und Fig. 3 zeigt die Verbindungsleitung 9 mit der elektromagnetischen Entstörvorrichtung 13 aus Fig. 2 ohne den übrigen Stromrichterturm 1.

Der elektrische Verbindungsleiter 9 ist als Stromschiene 15 ausgestaltet.

Zumindest in einem Bereich 17, in dem die elektromagnetische Entstörvorrichtung 13 angeordnet ist, weist der elektrische Verbindungsleiter 9 einen runden Querschnitt auf. Dazu erstreckt sich der elektrische Verbindungsleiter 9 in dem Bereich 17 als Rundleiter 21, der mit dem übrigen, als Stromschiene 15 gebildeten, elektrischen Verbindungsleiter 9 über geeignete Verbindungselemente 23 elektrisch leitend verbunden ist.

Zusätzlich ist der Rundleiter 21 mit Befestigungselementen 25 verbunden, die an geeigneten Komponenten des Stromrichterturms 1, befestigt sein können. Dadurch kann verhindert werden, dass die Stromschiene 15 das Gewicht der elektromagnetischen Entstörvorrichtung 13 tragen muss. Die Befestigungselemente 25 können aus elektrisch isolierendem Material gefertigt sein.

Die vorbeschriebene Art der Anordnung der elektromagnetischen Entstörvorrichtungen 13 am Stromrichterturm 1 erlaubt einen platzneutralen Einbau im Stromrichterturm 1. Darüber hinaus können eine solche elektromagnetischen Entstörvorrichtungen 13 auf einfache Weise nachgerüstet werden.

Die elektrische Entstörvorrichtung 13 hat insgesamt eine hohlzylindrische Form, wobei sich der Rundleiter 21 durch das Innere des Hohlzylinders erstreckt. Die elektrische Entstörvorrichtung 13 ist vorzugsweise aus einer Mehrzahl von magnetischen Ringkernen 27, aufgebaut. Dies ist in Fig. 3 gestrichelt angedeutet. Zentrale Öffnungen 29 der Ringkerne 27 sind miteinander fluchtend angeordnet und bilden einen Kanal 31 für den Rundleiter 21, der durch den Kanal 31 hindurchragt.

Die elektromagnetische Entstörvorrichtung 13 ist vorzugsweise ausgestaltet, Frequenzen von 0,009-30 MHz, insbesondere von 0,5-30 MHz zu dämpfen.

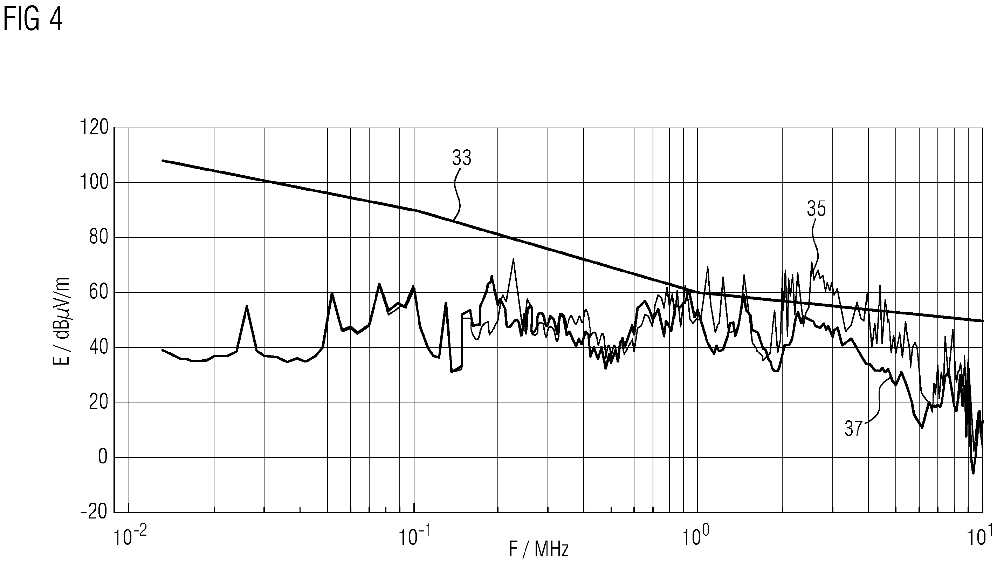

Fig. 4 zeigt eine Simulation der Emissionen einer Stromrichteranlage mit und ohne elektromagnetischen Entstörvorrichtungen. Dabei repräsentiert die X-Achse die Frequenz F in MHz und die Y-Achse die Emission E in dBµV/m.

Die durchgezogene Linie 33 stellt die maximal zulässige Emission nach Empfehlungen gemäß CIGRE 391 dar (CIGRE: Conseil International des Grands Réseaux Électriques). Die mit 35 gekennzeichnete Kurve stellt eine Simulation der Emission einer Stromrichteranlage ohne elektromagnetische Entstörvorrichtungen dar. Die mit 37 gekennzeichnete Kurve stellt die Emission einer Stromrichteranlage, deren Stromrichtertürme 1 mit den elektromagnetischen Entstörvorrichtungen 13 versehen sind, dar.

Die Emission der mit den elektromagnetischen Entstörvorrichtungen 13 versehenen Anlage liegt im gesamten Frequenzbereich unterhalb den Empfehlungen gemäß CIGRE 391.

### Bezugszeichen

- 1: Stromrichterturm
- 3: Stromrichtermodul
- 5: Etage
- 7: Stütze
- 9: Verbindungsleiter
- 11: Anschlussleitung
- 13: elektromagnetische Entstörvorrichtung
- 15: Stromschiene
- 17: Bereich des Verbindungsleiters
- 21: Rundleiter
- 23: Verbindungselement
- 25: Befestigungselement
- 27: Ringkern
- 29: Zentrale Öffnung
- 31: Kanal
- 33: Zulässige Emission
- 35: Emission ohne Entstörvorrichtungen
- 37: Emission mit Entstörvorrichtungen

## Patentansprüche

1. Stromrichterturm (1) mit einer Mehrzahl von Stromrichtermodulen (3), mit einer Mehrzahl von elektrischen Verbindungsleitern (9), von denen jeweils ein Verbindungsleiter (9) je zwei der Stromrichtermodule (3) miteinander oder eines der Stromrichtermodule (3) mit einer Anschlussleitung (11) des Stromrichterturms (1) verbindet, **dadurch gekennzeichnet, dass** wenigstens einer der elektrischen Verbindungsleiter (9) mit einer elektromagnetischen Entstörvorrichtung (13) versehen ist.

2. Stromrichterturm (1) nach Anspruch 1, **dadurch gekennzeichnet, dass** der Stromrichterturm (1) eine Mehrzahl übereinander angeordneter Etagen (5) aufweist, wobei auf jeder Etage (5) eine Teilmenge der Mehrzahl von Stromrichtermodulen (3) angeordnet ist, und wobei jede Etage (5) mit wenigstens einer elektromagnetischen Entstörvorrichtung (13) versehen ist.

3. Stromrichterturm (1) nach Anspruch 2, **dadurch gekennzeichnet, dass** genau eine elektromagnetische Entstörvorrichtung (13) je Etage (5) vorgesehen ist.

4. Stromrichterturm (1) nach Anspruch 2 oder 3, **dadurch gekennzeichnet, dass** die wenigstens eine elektromagnetische Entstörvorrichtung (13) einer Etage (5) an einem elektrischen Verbindungsleiter (9) angeordnet ist, der zwei Stromrichtermodule (3) benachbarter Etagen (5) miteinander verbindet.

5. Stromrichterturm (1) nach einem der Ansprüche 1 bis 4, **dadurch gekennzeichnet, dass** wenigstens ein elektrischer Verbindungsleiter (9) durch eine Stromschiene (15) gebildet ist.

6. Stromrichterturm (1) nach einem der Ansprüche 1 bis 5, **dadurch gekennzeichnet, dass** wenigstens ein elektrischer Verbindungsleiter (9) zumindest in einem Bereich (17), in dem eine der elektromagnetischen Entstörvorrichtungen (13) angeordnet ist, einen runden Querschnitt hat.

7. Stromrichterturm (1) nach einem der Ansprüche 1 bis **6, dadurch gekennzeichnet, dass** wenigstens eine der elektromagnetischen Entstörvorrichtungen (13) aus einer Mehrzahl von magnetischen Ringkernen (27) aufgebaut ist, wobei zentrale Öffnungen (29) der Ringkerne (27) miteinander fluchtend angeordnet sind und einen Kanal (31) bilden, wobei einer der elektrischen Verbindungsleiter (9) zumindest abschnittsweise durch den Kanal (31) hindurchragt.

8. Stromrichterturm (1) nach einem der Ansprüche 1 bis **7, dadurch gekennzeichnet, dass** die wenigstens eine elektromagnetische Entstörvorrichtung (13) ausgestaltet ist, Frequenzen von 0,009-30 MHz, insbesondere von **0,5-**30 MHz zu dämpfen.

9. Stromrichteranlage mit einer Mehrzahl von Stromrichtertürmen (1) nach einem der Ansprüche 1 bis 8.
